# EUROPEAN PATENT APPLICATION

(11) **EP 1 995 898 A2**
(43) Date of publication of application: **26.11.2008**
(21) Application number: 08251500.8
(22) Date of filing: 23.04.2008
(51) Int. Cl.: H04H 60/11

(54) **Reception device and method and program**

(30) Priority: 23.05.2007 JP 2007136344
(71) Applicant: Sony Corporation, Tokyo (JP)
(72) Inventor: Kaida, Takayuki, Tokyo (JP)
(74) Representative: Mills, Julia

(57) **Abstract**

Disclosed herein is a reception device, characterized by, a reception section (2), an amplification unit (21, 23 or 25), a demodulation section (41), an error correction section (43, 46 or 49), an error rate calculation section (61, 62 or 63) an operation changeover block (65c), a comparison section (65b), and an adjustment unit (65).

## Description

This invention relates to a reception device and method and a program, and more particularly to a reception device and method and a program for receiving a broadcasting wave.

In Japan, regarding a reception method for a broadcasting wave for use with a mobile communication apparatus, a plurality of channels are synthesized for individual frequency bands and transmitted as a broadcasting wave. Meanwhile, in Europe and so forth, standards called DVB-H are decided toward a target of suppression of the power consumption of a reception device to 100 mW or less in order to achieve reduction of the power consumption of a tuner. The standards DVB-H are established for ground digital broadcasting for potable telephone sets settled by the DVB (Digital Video Broadcasting Project) which is a standardization organization for digital broadcasting.

The DVB-H is characterized in that it adopts the concept of "time slice" and "burst transmission" in order to achieve reduction of the power consumption of a reception device. According to the DVB-H, programs are transmitted by time division multiplex transmission, and a reception device is turned on and off carefully. When multimedia data for portable telephones including video data are multiplexed into a transport stream of MPEG (Moving Picture Experts Group) 2, a broadcasting station temporarily occupies a wide frequency band for individual programs to transmit the multimedia data in a burst (burst transmission). Where a plurality of programs are multiplexed, they are transmitted while time periods occupied thereby are displaced from each other by several hundreds seconds to several seconds (a transmission unit of each program is called time slice). A reception device ready for the DVB-H operates only when a desired signal arrives thereat. In order to determine on/off timings of the reception device, the transport stream transmits also information relating to a timing at which a signal of a desired channel is to arrive next. This is disclosed, for example, in Nikkei Electronics, February 2, 2004.

Several proposals have been made for power saving and enhancement of the reception performance of a reception device for the DVB-H. One of such proposals is disclosed in Japanese Patent Publication No. 2006-523402.

Incidentally, reception device of the DVB-H system are frequently incorporated in a battery-driven system like a portable telephone set. Therefore, reduction of the power consumption is demanded strongly, and also enhancement of the reception performance is demanded.

In order to satisfy both of low power consumption and high performance at the same time, usually a characteristic of a reception device is changed in response to a current state of a radio wave, that is, to a state of a signal being received.

However, it is difficult to use only a function possessed by a reception device to particularly grasp a current state of a radio wave. Therefore, it is a usual countermeasure to change conditions of a reception device several times actually and search for optimum setting conditions based on information which can be detected comparatively easily in the reception device such as the signal to noise ratio, modulation error rate and bit error rate.

Where the state of a radio wave is stable, when the radio wave is to be received for the first time, such a method as described above can be used to search out optimum values. However, where the state of the radio wave continuously varies as in mobile communication, it is demanded for the reception device to follow up the optimum conditions.

However, in a transmission system wherein data are successively sent, if a characteristic of a reception device is changed, then deterioration or miss of data usually occurs in a moment in which the characteristic is changed or when the characteristic is changed to a condition which is not suitable for the state of the radio wave. Therefore, it is difficult to detect optimum characteristics and automatically change over the characteristic conditions without any deterioration or miss of data during reception.

Therefore it is demanded to provide a reception device and method and a program which make it possible to receive a broadcasting wave, which is transmitted in a time-division multiplexed state, normally in an optimum state.

Various respective aspects and features of the invention are defined in the appended claims. Combinations of features from the dependent claims may be combined with features of the independent claims as appropriate and not merely as explicitly set out in the claims.

According to an embodiment of the present invention, there is provided a reception device, characterized by:
a reception section (2) configured to receive a broadcasting wave with which multi-channel programs are transmitted time-divisionally;
an amplification unit (21, 23 or 25) configured to amplify a broadcasting signal based on the broadcasting wave received by the reception section (2);
a demodulation section (41) configured to demodulate the broadcasting signal amplified by the amplification unit (21, 23 or 25);
an error correction section (43, 46 or 49) configured to correct errors generated upon the demodulation by the demodulation section (41);
an error rate calculation section (61, 62 or 63) configured to calculate error rates of the errors corrected by the error correction section (43, 46 or 49);
an operation changeover block (65c) configured to change over operation of the amplification unit (21, 23 or 25) between or among a plurality of operation states;
a comparison section (65b) configured to compare the error rates obtained for the plurality of operation states to which the operation of the amplification unit (21, 23 or 25) is changed over by the operation changeover block (65c); and
an adjustment unit (65) configured to adjust the operation state of the amplification unit (21, 23 or 25) to that one of the operation states which exhibits the lowest error rate based on a result of the comparison by the comparison section (65b).

According to another embodiment of the present invention, there is provided a reception method, characterized by:
a reception step (S3) of receiving a broadcasting wave with which multi-channel programs are transmitted time-divisionally;
an amplification step (S4, S5 or S7) of amplifying a broadcasting signal based on the broadcasting wave received by the process at the reception step (S3);
a demodulation step (S21) of demodulating the broadcasting signal amplified by the process at the amplification step (S4, S5 or S);
an error correction step (S23, S29 or S36) of correcting errors generated upon the demodulation by the process at the demodulation step (S21);
an error rate calculation step (S84, S88 or S91) of calculating error rates of the errors corrected by the process at the error correction step (S23, S29 or S36);
an operation changeover step (S51, S54, S57, S60, S63 or S66) of changing over operation at the amplification step (S4, S5 or S7) between or among a plurality of operation states;
a comparison step (S69) of comparing the error rates obtained for the plurality of operation states to which the operation at the amplification step (S4, S5 or S7) is changed over by the process at the operation changeover step (S51, S54, S57, S60, S63 or S66); and
an adjustment step (S70) of adjusting the operation state at the amplification step (S4, S5 or S7) to that one of the operation states which exhibits the lowest error rate based on a result of the comparison by the process at the comparison step (S69).

According to yet annother embodiment of the present invention, there is provided a program, characterized in that the program causes a computer to execute a process which includes:
a reception step (S3) of receiving a broadcasting wave with which multi-channel programs are transmitted time-divisionally;
an amplification step (S4, S5 or S7) of amplifying a broadcasting signal based on the broadcasting wave received by the process at the reception step (S3);
a demodulation step (S21) of demodulating the broadcasting signal amplified by the process at the amplification step (S4, S5 or S7);
an error correction step (S23, S29 or S36) of correcting errors generated upon the demodulation by the process at the demodulation step (S21);
an error rate calculation step (S84, S88 or S91) of calculating error rates of the errors corrected by the process at the error correction step (S23, S29 or S36);
an operation changeover step (S51, S54, S57, S60, S63 or S66) of changing over operation at the amplification step (S4, S5 or S7) between or among a plurality of operation states;
a comparison step (S69) of comparing the error rates obtained for the plurality of operation states to which the operation at the amplification step (S4, S5 or S7) is changed over by the process at the operation changeover step (S51, S54, S57, S60, S63 or S66); and
an adjustment step (S70) of adjusting the operation state at the amplification step (S4, S5 or S7) to that one of the operation states which exhibits the lowest error rate based on a result of the comparison by the process at the comparison step (S69).

According to yet another embodiment of the present invention, there is provided a program storage medium storing the program which causes a computer to execute a process characterized by:
a reception step (S3) of receiving a broadcasting wave with which multi-channel programs are transmitted time-divisionally;
an amplification step (S4, S5 or S7) of amplifying a broadcasting signal based on the broadcasting wave received by the process at the reception step (S3);
a demodulation step (S21) of demodulating the broadcasting signal amplified by the process at the amplification step (S4, S5 or S7);
an error correction step (S23, S29 or S36) of correcting errors generated upon the demodulation by the process at the demodulation step (S21);
an error rate calculation step (S84, S88 or S91) of calculating error rates of the errors corrected by the process at the error correction step (S23, S29 or S36);
an operation changeover step (S51, S54, S57, S60, S63 or S66) of changing over operation at the amplification step (S4, S5 or S7) between or among a plurality of operation states;
a comparison step (S69) of comparing the error rates obtained for the plurality of operation states to which the operation at the amplification step (S4, S5 or S7) is changed over by the process at the operation changeover step (S51, S54, S57, S60, S63 or S66); and
an adjustment step (S70) of adjusting the operation state at the amplification step (S4, S5 or S7) to that one of the operation states which exhibits the lowest error rate based on a result of the comparison by the process at the comparison step (S69).

Embodiments of the invention will now be described with reference to the accompanying drawings, throughout which like parts are referred to by like references, and in which:
FIG. 1 is a block diagram showing an example of a configuration of a reception device to which an embodiment of the present invention is applied;
FIG. 2 is a diagrammatic view illustrating a broadcasting signal transmitted in a time-division multiplexed state;
FIG. 3 is a flow chart illustrating a reception process of the reception device;
FIG. 4 is a flow chart illustrating a demodulation process of the reception device;
FIG. 5 is a flow chart illustrating an adjustment process of the reception device;
FIG. 6 is a flow chart illustrating an error rate calculation process of the reception device; and
FIG. 7 is a block diagram illustrating an example of a configuration of a personal computer.

Before a preferred embodiment of the present invention is described in detail, a corresponding relationship between several features recited in the accompanying claims and particular elements of the preferred embodiment described below is described. The description, however, is merely for the confirmation that the particular elements which support the invention as recited in the claims are disclosed in the description of the embodiment of the present invention. Accordingly, even if some particular element which is recited in description of the embodiment is not recited as one of the features in the following description, this does not signify that the particular element does not correspond to the feature. On the contrary, even if some particular element is recited as an element corresponding to one of the features, this does not signify that the element does not correspond to any other feature than the element.

Further, the following description does not signify that the prevent invention corresponding to particular elements described in the embodiment of the present invention is all described in the claims. In other words, the following description does not deny the presence of an invention which corresponds to a particular element described in the description of the embodiment of the present invention but is not recited in the claims, that is, the description does not deny the presence of an invention which may be filed for patent in a divisional patent application or may be additionally included into the present patent application as a result of later amendment to the claims.

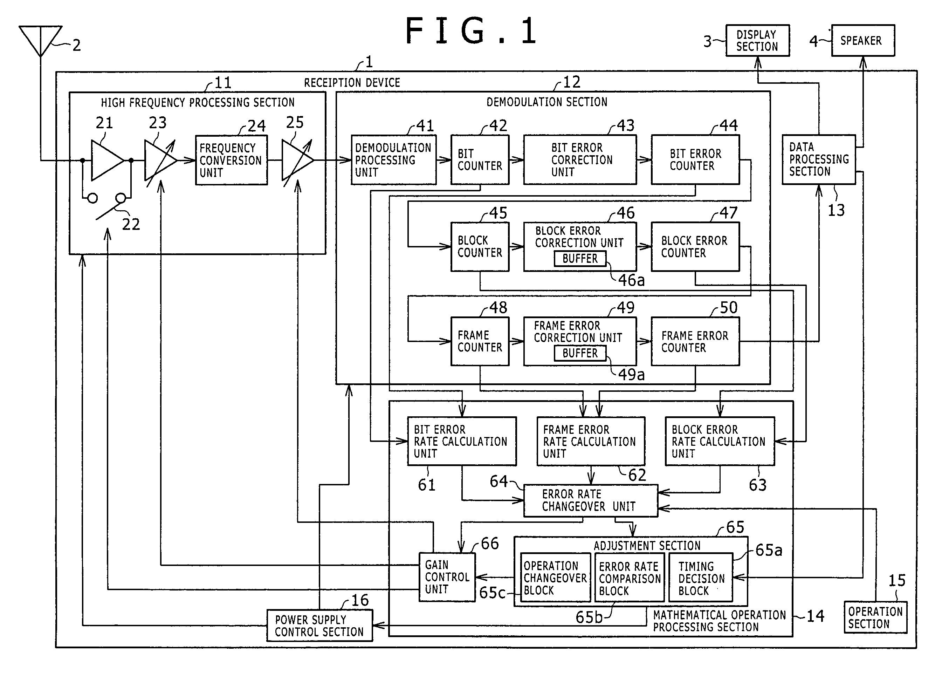

According to an embodiment of the present invention, there is provided a reception device, characterized by a reception section (for example, an antenna 2 shown in FIG. 1) configured to receive a broadcasting wave with which multi-channel programs are transmitted time-divisionally, an amplification unit (for example, an amplification unit 21 or a variable amplification unit 23 or 25 shown in FIG. 1) configured to amplify a broadcasting signal based on the broadcasting wave received by the reception section, a demodulation section (for example, a demodulation processing unit 41 shown in FIG. 1) configured to demodulate the broadcasting signal amplified by the amplification unit, an error correction section (for example, a bit error correction unit 43, a block error correction unit 46 or a frame error correction unit 49 shown in FIG. 1) configured to correct errors generated upon the demodulation by the demodulation section, an error rate calculation section (for example, a bit error rate calculation unit 61, a frame error rate calculation unit 62 or a block error rate calculation unit 63 shown in FIG. 1) configured to calculate error rates of the errors corrected by the error correction section, an operation changeover block (for example, an operation changeover block 65c shown in FIG. 1) configured to change over operation of the amplification unit between or among a plurality of operation states, a comparison section (for example, a first error rate comparison block 65b shown in FIG. 1) configured to compare the error rates obtained for the plurality of operation states is changed over by the operation changeover block, and an adjustment unit (for example, an adjustment unit 65 shown in FIG. 1) configured to adjust the operation state of the amplification unit to that one of the operation states which exhibits the lowest error rate based on a result of the comparison by the comparison section.

The reception device may be configured such that, at a timing at which the reception section does not receive the broadcasting wave of a selected one of the multi-channel programs transmitted in a time-division multiplexed form, the operation changeover block (for example, the operation changeover block 65c shown in FIG. 1) changes over the operation state of the amplification unit between or among the plurality of operation states and the comparison section (for example, the first error rate comparison block 65b shown in FIG. 1) compares the error rates for the individual operation states between or among which the operation state of the amplification unit is changed over by the operation changeover block and then the adjustment unit (for example, the adjustment unit 65 shown in FIG. 1) adjusts the operation state of the amplification unit to that one of the operation states which exhibits the lowest error rate based on a result of the comparison by the comparison section.

The reception device may be configured such that the amplification unit includes a first amplification unit (for example, the amplification unit 21 shown in FIG. 1) having a bypass function (for example, a bypass switch 22 shown in FIG. 1) and configured to carry out fixed amplification, a second amplification unit (for example, the variable amplification unit 23 shown in FIG. 1) configured to variably amplify the signal amplified by the first amplification unit, a frequency conversion unit (for example, a frequency conversion unit 24 shown in FIG. 1) configured to frequency convert the signal amplified by the second amplification unit, and a third amplification unit (for example, the variable amplification unit 25 shown in FIG. 1) configured to variably amplify the signal frequency converted by the frequency conversion unit, the operation changeover block (for example, the operation changeover block 65c shown in FIG. 1) changing over the combination of an on/off state of the bypass function and amplification factors of the second and third amplification unit to change over the operation state of the amplification unit, the adjustment unit (for example, the adjustment unit 65 shown in FIG. 1) changing over the combination of the on/off state of the bypass function and the amplification factors of the second and third amplification unit based on a result of the comparison by the comparison section to change over the operation state of the amplification unit to adjust the operation state of the amplification unit to that one of the operation states which exhibits the lowest error rate.

The error calculation section (for example, the bit error rate calculation unit 61, frame error rate calculation unit 62 or block error rate calculation unit 63 shown in FIG. 1) may calculate one of a signal to noise ratio, a modulation error rate, a bit error rate, a block error rate and a frame error rate as the error rate of the errors to be corrected by the error rate correction section.

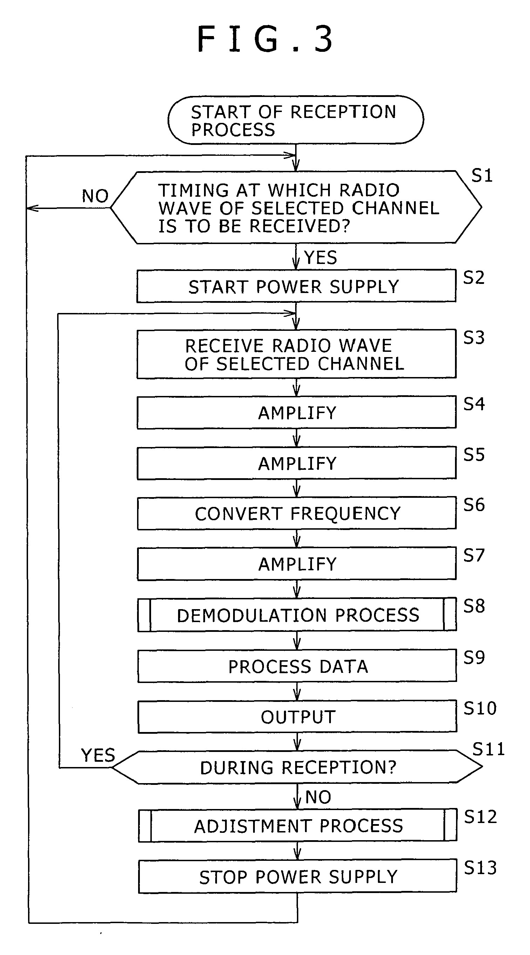

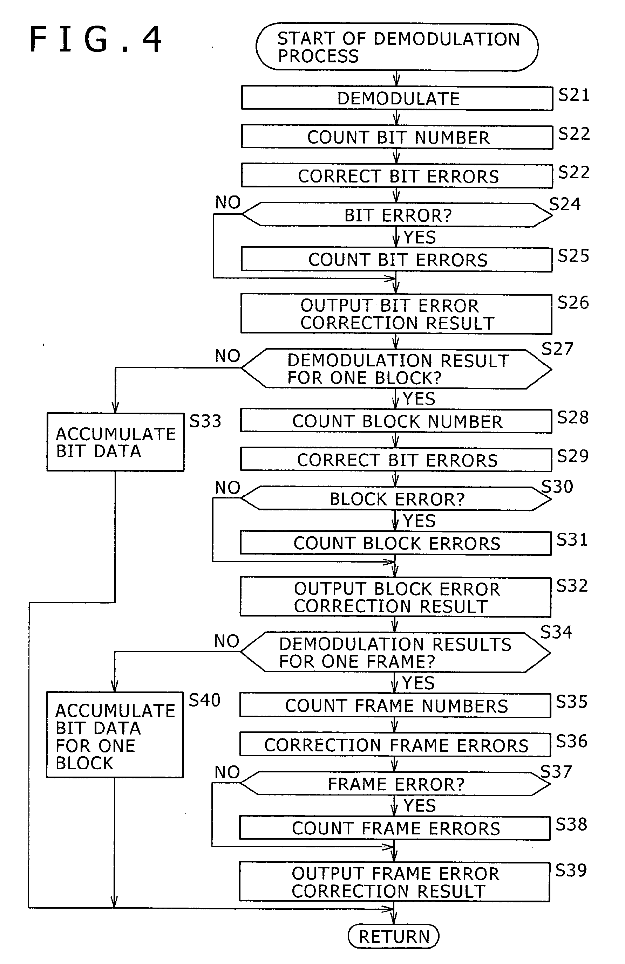

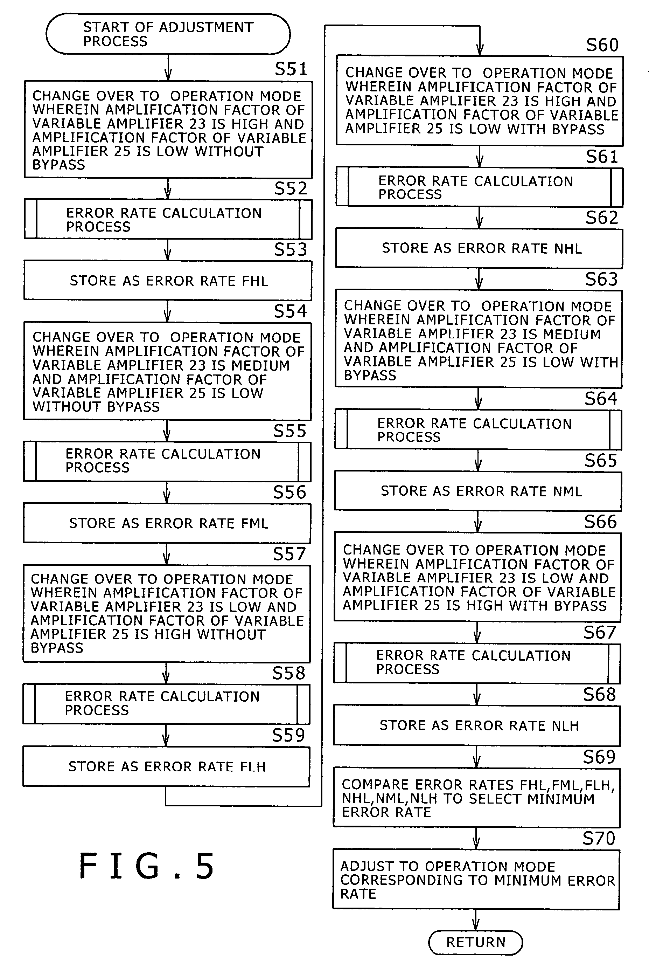

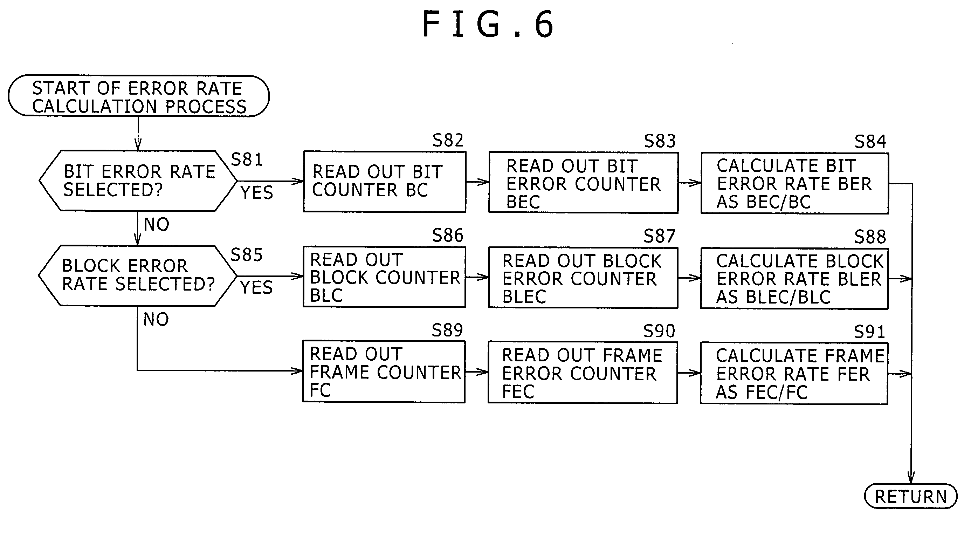

According to another embodiment of the present invention, there are provided a reception method and a program, characterized by a reception step (for example, a step S3 of FIG. 3) of receiving a broadcasting wave with which multi-channel programs are transmitted time-divisionally, an amplification step (for example, a step S4, S5 or S7) of amplifying a broadcasting signal based on the broadcasting wave received by the process at the reception step, a demodulation step (for example, a step S21 of FIG. 4) of demodulating the broadcasting signal amplified by the process at the amplification step, an error correction step (for example, a step S23, S29 or S36 of FIG. 4) of correcting errors generated upon the demodulation by the process at the demodulation step, an error rate calculation step (for example, a step S84, S88 or S91 of FIG. 6) of calculating error rates of the errors corrected by the process at the error correction step, an operation changeover step (for example, a step S51, S54, S57, S60, S63 or S66 of FIG. 5) of changing over operation at the amplification step between or among a plurality of operation states, a comparison step (for example, a step S69 of FIG. 5) of comparing the error rates obtained for the plurality of operation states to which the operation at the amplification step is changed over by the process at the operation changeover step, and an adjustment step (for example, a step S70 of FIG. 5) of adjusting the operation state at the amplification step to that one of the operation states which exhibits the lowest error rate based on a result of the comparison by the process at the comparison step.

FIG. 1 shows an example of a configuration of a reception device to which an embodiment of the present invention is applied.

Referring to FIG. 1, the reception device 1 shown receives a broadcasting wave of multi-channel programs, which is transmitted in a time-division multiplexed form as represented by the DVB-H (Digital Video Broadcasting Handheld) system, through an antenna 2. Then, the reception device 1 causes a display section 3, which may be a CRT (Cathode Ray Tube), an LCD (Liquid Crystal Display) apparatus or the like to output the received broadcasting wave as an image. Further, the reception device 1 causes a speaker 4 to output the received broadcasting wave as sound.

A high frequency processing section 11 includes an amplification unit 21, a bypass switch 22, a variable amplification unit 23, a frequency conversion unit 24 and another variable amplification unit 25. The high frequency processing section 11 is driven by power supplied from a power supply control section 16 to highfrequency process a broadcasting signal received by the antenna 2 and supply a resulting signal to a demodulation section 12.

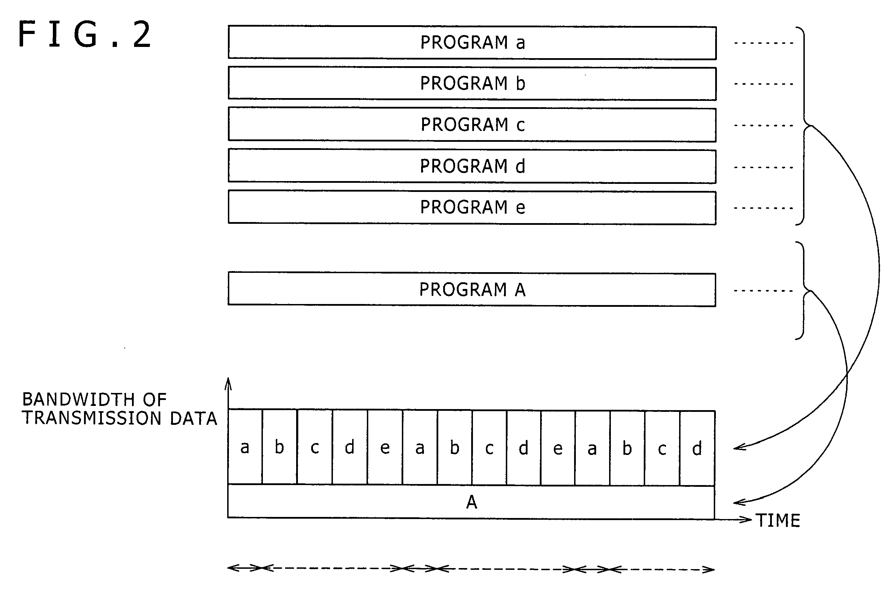

Here, the DVB-H system of transmitting multi-channel broadcasting signals in a time-division multiplexed form is described with reference to FIG. 2. Where programs a to e of 5 channels are time-division multiplexed to produce a plurality of broadcasting signals of multi-channels as seen on the uppermost stage of FIG. 2, different from a broadcasting signal of a program A transmitted to an ordinary television receiver as shown at the second stage from above in FIG. 2, the channel to be used for transmission is successively changed at predetermined time intervals like a broadcasting signal of the program a, a broadcasting signal of the program b, a broadcasting signal of the program c, a broadcasting signal of the program d, a broadcasting signal of the program d, with a large bandwidth to transmit the broadcasting signals as shown at the third stage from above of FIG. 2. The broadcasting signal of the program A transmitted to an ordinary television receiver is continuously broadcast as indicated on the fourth stage from above of FIG. 2.

Accordingly, where the program a is selected by an operation section 15, as indicated on the lowermost stage of FIG. 2, only within a period within which the program a which corresponds to a period indicated by a double-sided arrow mark of a solid line in FIG. 2 is being received, a broadcasting signal is received and a signal representing that a broadcasting signal of the selected program is being received is supplied to a mathematical operation processing section 14. It is to be noted that a period indicated by a double-sided arrow mark of a broken line in FIG. 2 is a period within which broadcasting signals of the programs other than the program a are distributed.

Referring back to FIG. 1, the amplification unit 21 of the high frequency processing section 11 amplifies a broadcasting signal received in a fixed magnification and supplies the amplified broadcasting signal to the variable amplification unit 23. The bypass switch 22 is controlled by a gain control unit 66 of the mathematical operation processing section 14 such that it is normally in an off state, but is placed into an on state if there is the possibility that amplification by the amplification unit 21 may cause saturation because the intensity of the broadcasting signal received is very high or in a like case. When the amplification unit 21 is in an on state, the broadcasting signal bypasses the amplification unit 21 and is supplied to the variable amplification unit 23.

The variable amplification unit 23 has an amplification factor which is controlled by the gain control unit 66, and amplifies a broadcasting signal supplied thereto with a controlled magnification and then supplies the amplified broadcasting signal to the frequency conversion unit 24. The frequency conversion unit 24 converts the frequency of the broadcasting signal amplified by the variable amplification unit 23 and supplies the broadcasting signal of the converted frequency to the variable amplification unit 25. The variable amplification unit 25 has an amplification factor controlled by the gain control unit 66, and amplifies the broadcasting signal supplied thereto from the frequency conversion unit 24 with a controlled magnification and then supplies the amplified broadcasting signal to the demodulation section 12.

The demodulation processing unit 41 of the demodulation section 12 demodulates a broadcasting signal supplied thereto from the variable amplification unit 25 and supplies the demodulated broadcasting signal to a bit counter 42.

The bit counter 42 counts the number of demodulated bit data and supplies the demodulated bit data to a bit error correction unit 43. The bit error correction unit 43 corrects data errors in a unit of a bit, for example, in accordance with a Viterbi algorithm and supplies resulting data to a bit error counter 44. Where errors have been included in the bit data and corrected by the bit error correction unit 43, the bit error counter 44 counts the number of the data and supplies the corrected bit data supplied to the bit error counter 44 to a block counter 45.

The block counter 45 counts the number of blocks when the number of demodulated bit data comes to one block for which an image process is to be executed such as, for example, a DCT block in a DCT (Discrete Cosine Transform) process. The block counter 45 supplies the demodulated bit data to a block error correction unit 46. The block counter 45 is formed, more particularly, from a byte counter and counts one block every time 204 bytes which correspond to one block are counted by the byte counter. The block error correction unit 46 accumulates bit data supplied thereto through the block counter 45 into a buffer 46a. Then, if data for one block required for processing in accordance with the Reed-Solomon algorithm are accumulated, then the block error correction unit 46 uses the data for one block to correct data errors in a unit of a block in accordance with the Reed-Solomon algorithm and supplies resulting data to a block error counter 47. The block error counter 47 counts, where errors have been originally included in the data and corrected by the block error correction unit 46, the number of corrected blocks and supplies the corrected data supplied thereto in a unit of a block to a frame counter 48.

The frame counter 48 counts the number of frames when the number of demodulated bit data becomes equal to that corresponding to one frame required for processing in accordance with the Reed-Solomon algorithm. The frame counter 48 supplies the demodulated bit data to a frame error correction unit 49. The frame error correction unit 49 accumulates bit data supplied thereto through the frame counter 48 into a buffer 49a. If data for one frame required for processing in accordance with the Reed-Solomon algorithm are accumulated, then the frame error correction unit 49 uses the data for one frame to correct data errors in a unit of a frame in accordance with the Reed-Solomon algorithm, and supplies resulting data to a frame error counter 50. The frame error counter 50 counts, where errors have been originally included in the data and corrected by the frame error correction unit 49, the number of corrected blocks and supplies the corrected data in a unit of a frame supplied thereto to a data processing section 13.

The data processing section 13 produces an image based on data supplied thereto through the frame error counter 50 after errors are corrected by the frame error correction unit 49, and causes the display section 3 to display the image. Further, the data processing section 13 causes the speaker 4 to output sound. Furthermore, since the broadcasting wave includes information of a next transmission timing of each of the time-division multiplexed channels, the data processing section 13 recognizes a reception timing based on the information and supplies the recognized information to an adjustment unit 65. A timing decision block 65a of the adjustment unit 65 decides, based on the information, a timing at which a broadcasting signal of a channel selected by the operation section 15 is not being received, and supplies the decided timing to the power supply control section 16.

A bit error rate calculation unit 61 is controlled by an error rate changeover unit 64, and calculates a bit error rate BER based on a value BC of the frame counter 48 and a value BEC of the bit error counter 44 and supplies the calculated bit error rate BER to the error rate changeover unit 64.

A frame error rate calculation unit 62 is controlled by the error rate changeover unit 64, and calculates a frame error rate FER based on a value FC and a value FEC of the frame counter 48 and the frame error counter 50 and supplies the calculated frame error rate FER to the error rate changeover unit 64.

A block error rate calculation unit 63 is controlled by the error rate changeover unit 64, and calculates a bit error rate BER based on a value BLC of the block counter 45 and a value BLEC of the block error counter 47 and supplies the bit error rate BER to the error rate changeover unit 64.

The error rate changeover unit 64 issues, based on an operation signal from the operation section 15, a request for and acquires an error rate whose use is selected from among the bit error rate, block error rate and frame rate to and from the bit error rate calculation unit 61, block error rate calculation unit 63 or frame error rate calculation unit 62. Then, the error rate changeover unit 64 supplies the acquired error rate to the adjustment unit 65.

The adjustment unit 65 includes a timing decision block 65a, an error rate comparison block 65b and an operation changeover block 65c. The adjustment unit 65 controls the timing decision block 65a to detect a timing at which a broadcasting signal of a channel selected by the operation section 15 is not received. Then, when the timing is detected, the adjustment unit 65 controls the operation changeover block 65c to control the gain control unit 66 to carry out changeover of an operation mode among a plurality of operation modes which are formed from combinations of on and off states of the bypass switch 22 and amplifications of the variable amplification units 23 and 25 at predetermined intervals. Further, the adjustment unit 65 compares error rates in the operation modes and controls the gain control unit 66 so as to select one of the operation modes which provides the lowest error rate and which is a combination of an on/off state of the bypass switch 22 and amplification factors of the variable amplification units 23 and 25.

The power supply control section 16 supplies power to the high frequency processing section 11 and the demodulation section 12 based on information, supplied from the timing decision block 65a, of a timing at which a broadcasting signal selected by the operation section 15 is transmitted so as to allow operation of the high frequency processing section 11 and the demodulation section 12.

Now, a reception process of the reception device 1 of FIG. 1 is described with reference to a flow chart of FIG. 3.

First at step S1, the timing decision block 65a decides whether or not the present point of time corresponds to a timing at which a broadcasting signal selected by the operation section 15 is to be received and repeats a similar process till a timing at which the broadcasting signal is to be received. Then, if it is decided at step S1 that the present point of time corresponds to a timing at which the broadcasting signal selected by the operation section 15 is to be received, then the power supply control section 16 supplies power to the high frequency processing section 11 and the demodulation section 12 to place the high frequency processing section 11 and the demodulation section 12 into an operable state at step S2.

At step S3, the timing decision block 65a receives a broadcasting signal transmitted thereto through the antenna 2 and supplies the broadcasting signal to the amplification unit 21 and the bypass switch 22.

It is to be noted that, in the process for the first time, since the data processing section 13 cannot sufficiently extract a timing at which the broadcasting signal selected by the operation section 15 is to be received, it starts the reception independently of the decision of the timing decision block 65a. In other words, the data processing section 13 executes the process assuming that normally it is a timing at which the broadcasting signal is to be received. Further, the adjustment unit 65 places the bypass switch 22 into an off state, and sets the amplification factor of the variable amplification unit 23 to a high amplification factor H and sets the amplification factor of the variable amplification unit 25 to a rather low amplification factor L.

Although the amplification factors of the variable amplification units 23 and 25 can be set with particular values, in the following description, they are represented as a high amplification factor H, a medium amplification factor M and a low amplification factor L, which indicate a relative relationship of the amplification factors of the variable amplification units 23 and 25. Accordingly, that the variable amplification unit 23 has the high amplification factor H and the variable amplification unit 25 has the low amplification factor L indicates that the amplification factor of the variable amplification unit 23 is higher than the amplification factor of the variable amplification factor 25. On the other hand, that the variable amplification unit 23 has the medium amplification factor M and the variable amplification unit 25 has the low amplification factor L indicates that, although the amplification factor of the mathematical operation processing section 14 is higher than the amplification factor of the variable amplification unit 25, it is nearer to the amplification factor L of the variable amplification unit 25 when compared with that when the amplification factor of the variable amplification unit 23 is the high amplification factor H.

At step S4, the amplification unit 21 amplifies the broadcasting signal supplied thereto with a predetermined magnification and supplies the amplified broadcasting signal to the variable amplification unit 23.

At step S5, the variable amplification unit 23 amplifies the broadcasting signal supplied thereto with an amplification factor set by the adjustment unit 65 and supplies the amplified broadcasting signal to the frequency conversion unit 24.

At step S6, the frequency conversion unit 24 frequency converts the broadcasting signal of a high frequency supplied thereto in the form amplified by the variable amplification unit 23 to produce a broadcasting signal of a medium frequency and supplies the broadcasting signal of the medium frequency to the variable amplification unit 25.

At step S7, the variable amplification unit 25 amplifies the broadcasting signal supplied thereto from the frequency conversion unit 24 with an amplification factor set by the adjustment unit 65 and supplies the amplified broadcasting signal to the frequency conversion unit 24.

At step S8, the demodulation section 12 executes a demodulation process and supplies a result of the demodulation to the data processing section 13.

Here, the demodulation process is described with reference to a flow chart of FIG. 4.

At step S21, the demodulation processing unit 41 executes a demodulation process based on the broadcasting signal supplied thereto from the variable amplification unit 25 to demodulate the broadcasting signal and supplies the demodulated broadcasting signal to the bit counter 42.

At step S22, the bit counter 42 counts the number of bit data obtained by the demodulation process and supplies the demodulated bit data to the bit error correction unit 43.

At step S23, the bit error correction unit 43 corrects data errors in a unit of a bit in accordance with a Viterbi algorithm and supplies resulting data to the bit error counter 44.

At step S24, the bit error counter 44 decides whether or not the data have originally included errors and the errors have been corrected by the bit error correction unit 43. If it is decided that the data have originally included errors and the errors have been corrected by the bit error correction unit 43, then the bit error counter 44 counts the errors as bit error data at step S25.

Then at step S26, the bit error counter 44 supplies the bit data supplied thereto after corrected or bit data in a modulated form without the necessity for correction to the block counter 45.

It is to be noted that, if it is decided at step S27 that the data have not originally included errors and the errors have not been corrected by the bit error correction unit 43, then the process at step S25 is skipped.

At step S27, the block counter 45 decides based on the bit data supplied thereto whether or not results of demodulation for one block required by processing in accordance with the Reed-Solomon algorithm are stored in the block error correction unit 46, that is, whether or not bit data for one block required for processing in accordance with the Reed-Solomon algorithm are received. Then, if it is decided that results of demodulation for one block required for processing in accordance with the Reed-Solomon algorithm are stored, then the processing advances to step S28.

At step S28, the block counter 45 counts the number of blocks and supplies the demodulated bit data to the block error correction unit 46 when the number of demodulated bit data becomes equal to one block required for processing in accordance with the Reed-Solomon algorithm, for example, equal to one DCT block in a DCT (Discrete Cosine Transform) process.

At step 529, the block error correction unit 46 accumulates the bit data supplied thereto through the block counter 45 into the buffer 46a and uses the data for one block to correct data errors in a unit of a block, for example, in accordance with the Reed-Solomon algorithm. Then, the block error correction unit 46 supplies resulting data to the block error counter 47.

At step S30, the block error counter 47 decides whether or not errors have originally been included and have been corrected by the block error correction unit 46. Then, for example, if it is decided that errors have originally been included and have been corrected by the block error correction unit 46, then the block error counter 47 counts the number of the blocks at step S31.

At step S32, the block error counter 47 supplies the corrected data in a unit of a block supplied thereto to the frame counter 48.

It is to be noted that, if it is decided at step S27 that bit data for one block required for processing in accordance with the Reed-Solomon algorithm are not stored, then the block error correction unit 46 accumulates the bit data supplied thereto through the block counter 45 into the buffer 46a at step S33. Thereafter, the processing ends. On the other hand, if it is decided at step S30 that errors have not originally been included and have not been corrected by the block error correction unit 46, then the process at step S31 is skipped.

At step S34, the frame counter 48 decides based on the bit data supplied thereto whether or not demodulation results for one frame are stored in the frame error correction unit 49, that is, whether or not bit data for one block required for processing in accordance with the Reed-Solomon algorithm have been received. If it is decided that demodulation results for one frame required for processing in accordance with the Reed-Solomon algorithm are stored, then the processing advances to step S35.

At step S35, the frame counter 48 counts the number of frames and supplies the demodulated bit data to the frame error correction unit 49.

At step S36, the frame error correction unit 49 accumulates the bit data supplied thereto through the frame counter 48 into the buffer 49a and uses the data for one frame to correct data errors in a unit of a frame, for example, in accordance with the Reed-Solomon algorithm. Then, the frame error correction unit 49 supplies resulting data to the frame error counter 50.

At step S37, the frame error counter 50 decides whether or not errors have originally been included and have been corrected by the frame error correction unit 49. If it is decided that errors have originally been included and have been corrected by the frame error correction unit 49, then the frame error counter 50 counts the number of frames at step S38.

At step S39, the frame error counter 50 supplies the corrected data in a unit of a frame supplied thereto to the data processing section 13.

It is to be noted that, if it is decided at step S34 that bit data for one frame necessary for processing in accordance with the Reed-Solomon algorithm do not exist, then the frame error correction unit 49 accumulates bit data for one block supplied thereto through the frame counter 48 into the buffer 49a at step S40, whereafter the processing ends. On the other hand, if it is decided at step S37 that errors have not originally been included and have not been corrected by the frame error correction unit 49, then the processing at step S38 is skipped.

By the processes described above, the number of bit data, the number of blocks and the number of frames demodulated individually are counted by the bit counter 42, block counter 45 and frame counter 48, respectively. Further, the number of data with regard to which a bit error occurs, the number of data with regard to which a block error occurs and the number of data with regard to which a frame error occurs after the demodulation processes are carried out are counted by the bit error counter 44, block error counter 47 and frame error counter 50, respectively.

Referring back to FIG. 3, after the demodulation process is completed at step S8, the data processing section 13 executes, at step S9, a data process using an error correction result designated by the operation section 15 to produce an image signal and a sound signal. The data processing section 13 outputs the produced image signal and sound signal to the display section 3 and the speaker 4, respectively.

At step S10, the display section 3 and the speaker 4 output an image and sound, respectively.

At step S11, the adjustment unit 65 of the mathematical operation processing section 14 controls the timing decision block 65a to decide whether or not the state wherein the broadcasting signal selected by the operation section 15 is received continues. Then, if the reception continues, then the processing returns to step S2. In particular, while the broadcasting signal selected by the operation section 15 is being received, the processes at steps S3 to S11 are repeated.

Then, if it is decided at step S11 that the broadcasting signal selected by the operation section 15 ends, then the mathematical operation processing section 14 executes, at step S12, an adjustment process to adjust the bypass switch 22 and the variable amplification units 23 and 25.

Here, the adjustment process is described with reference to a flow chart of FIG. 5.

At step S51, the operation changeover block 65c of the adjustment unit 65 controls the gain control unit 66 to carry out changeover to an operation mode wherein the bypass switch 22 is off, the amplification factor of the variable amplification unit 23 is the high amplification factor H and the amplification factor of the variable amplification unit 25 is the low amplification factor L.

At step S52, the error rate comparison block 65b issues a request to the error rate changeover unit 64 to calculate an error rate. Consequently, the error rate changeover unit 64 controls one of the bit error rate calculation unit 61, frame error rate calculation unit 62 and block error rate calculation unit 63 to execute an error rate calculation process in accordance with the error correction method designated by the operation section 15 and acquires the calculated error rate.

Here, the error rate calculation process is described with reference to a flow chart of FIG. 6.

At step S81, the error rate changeover unit 64 decides whether or not the bit error rate is designated as the error rate. If it is decided at step S81 that the bit error rate is designated, then the error rate changeover unit 64 issues a request for a bit error rate to the bit error rate calculation unit 61 at step S82. In response to the request, the bit error rate calculation unit 61 accesses the bit counter 42 to read out the bit count BC.

At step S83, the bit error rate calculation unit 61 reads out the bit error count BEC from the bit error counter 44.

At step S84, the bit error rate calculation unit 61 calculates a bit error rate BER (= BEC/BC) based on the bit count BC and the bit error count BEC and supplies the bit error rate BER to the error rate changeover unit 64. The error rate changeover unit 64 supplies the bit error rate BER supplied thereto to the error rate comparison block 65b of the adjustment unit 65. It is to be noted that, in the calculation of the bit error rate BER, the bit count BC is the latest predetermined number, and the bit error count BEC is the error correction data bit number from among the latest predetermined number of bit data.

On the other hand, if it is decided at step S81 that the bit error rate is not designated, then the processing advances to step S85.

At step S85, the error rate changeover unit 64 decides whether or not the block error rate is designated. If it is decided at step S85 that the block error rate is designated, then at step S86 the error rate changeover unit 64 issues a request for a block error rate to the block error rate calculation unit 63. In response to the request, the block error rate calculation unit 63 accesses the block counter 45 to read out the block count BLC.

At step S87, the block error rate calculation unit 63 reads out the block error count BLEC from the block error counter 47.

At step S88, the block error rate calculation unit 63 calculates the block error rate BLER (= BLEC/BLC) based on the block count BLC and the block error count BLEC and supplies the block error rate BLER to the error rate changeover unit 64. The error rate changeover unit 64 supplies the block error rate BLER supplied thereto to the error rate comparison block 65b of the adjustment unit 65. It is to be noted that, in the calculation of the block error rate BLER, the block count BLC is the latest predetermined number, and the block error count BLEC is an error correction block number from among the data of the latest predetermined number of blocks.

On the other hand, if it is decided at step S85 that the block error rate is not designated, that is, if none of the bit error rate and the block error rate is demanded, then since this signifies that the frame error rate is demanded, the processing advances to step S89.

At step S89, the error rate changeover unit 64 issues a request for the frame error rate to the frame error rate calculation unit 62. In accordance with the request, the frame error rate calculation unit 62 accesses the frame counter 48 to read out the frame count FC.

At step S90, the frame error rate calculation unit 62 reads out the frame error count FEC from the frame error counter 50.

At step S91, the frame error rate calculation unit 62 calculates a frame error rate FER (= FEC/FC) based on the frame count FC and the frame error count FEC and supplies the frame error rate FER to the error rate changeover unit 64. The error rate changeover unit 64 supplies the frame error rate FER supplied thereto to the error rate comparison block 65b of the adjustment unit 65. It is to be noted that, in the calculation of the frame error rate FER, the frame count FC is the latest predetermined number, and the frame error count FEC is the error correction frame number from among the data of the latest predetermined number of frames.

By the processes described above, an error rate of the type designated so as to be used for adjustment of one of the bit error rate BER, block error rate BLER and frame error rate FER is calculated and supplied to the error rate comparison block 65b of the adjustment unit 65.

Referring back to FIG. 5, after the error rate calculation process described above is executed at step S52, the error rate comparison block 65b stores the error rate supplied thereto as an error rate FHL in an associated relationship with the type of the operation mode.

At step S54, the operation changeover block 65c of the adjustment unit 65 controls the gain control unit 66 to carry out changeover to the operation mode wherein the bypass switch 22 is off, the amplification factor of the variable amplification unit 23 is the medium amplification factor M and the amplification factor of the variable amplification unit 25 is the low amplification factor L.

At step S55, the error rate comparison block 65b issues a request to the error rate changeover unit 64 to calculate an error rate. As a result, the error rate changeover unit 64 controls one of the bit error rate calculation unit 61, frame error rate calculation unit 62 and block error rate calculation unit 63 to execute an error rate calculation process in accordance with the type of the error rate designated by the operation section 15 and acquires the calculated error rate. It is to be noted that the error rate calculation process in this instance is similar to the process described hereinabove with reference to the flow chart of FIG. 6, and therefore, overlapping description of the process is omitted herein to avoid redundancy. Further, this similarly applies also to the processes at steps S58, S61, S64 and S67, and therefore, overlapping description of the processes is omitted herein to avoid redundancy

At step S56, the error rate comparison block 65b stores the error rate supplied thereto as an error rate FML in an associated relationship with the type of the operation mode.

At step S57, the operation changeover block 65c of the adjustment unit 65 controls the gain control unit 66 to carry out changeover to the operation mode wherein the bypass switch 22 is off, the amplification factor of the variable amplification unit 23 is the low amplification factor L and the amplification factor of the variable amplification unit 25 is the high amplification factor H.

At step S58, the error rate comparison block 65b issues a request to the error rate changeover unit 64 to calculate an error rate.

At step S59, the error rate comparison block 65b stores the error rate supplied thereto as an error rate FLH in an associated relationship with the type of the operation mode.

At step S60, the operation changeover block 65c of the adjustment unit 65 controls the gain control unit 66 to carry out changeover to the operation mode wherein the bypass switch 22 is on, the amplification factor of the variable amplification unit 23 is the high amplification factor H and the amplification factor of the variable amplification unit 25 is the low amplification factor L.

At step S61, the error rate comparison block 65b issues a request to the error rate changeover unit 64 to calculate an error rate.

At step S62, the error rate comparison block 65b stores the error rate supplied thereto as an error rate NHL in an associated relationship with the type of the operation mode.

At step S63, the operation changeover block 65c of the adjustment unit 65 controls the gain control unit 66 to carry out changeover to the operation mode wherein the bypass switch 22 is on, the amplification factor of the variable amplification unit 23 is the medium amplification factor M and the amplification factor of the variable amplification unit 25 is the low amplification factor L.

At step S64, the error rate comparison block 65b issues a request to the error rate changeover unit 64 to calculate an error rate.

At step S65, the error rate comparison block 65b stores the error rate supplied thereto as an error rate NML in an associated relationship with the type of the operation mode.

At step S66, the operation changeover block 65c of the adjustment unit 65 controls the gain control unit 66 to carry out changeover to the operation mode wherein the bypass switch 22 is on, the amplification factor of the variable amplification unit 23 is the low amplification factor L and the amplification factor of the variable amplification unit 25 is the high amplification factor H.

At step S67, the error rate comparison block 65b issues a request to the error rate changeover unit 64 to calculate an error rate.

At step S68, the error rate comparison block 65b stores the error rate supplied thereto as an error rate NLH in an associated relationship with the type of the operation mode.

At step S69, the error rate comparison block 65b compares the error rates FHL, FML, FLH, NHL, NML and NLH with one another in magnitude to select the lowest error rate.

At step S70, the adjustment unit 65 controls the gain control unit 66 to establish an operation mode corresponding to the lowest error rate selected by the error rate comparison block 65b to adjust the operation of the bypass switch 22 and the variable amplification units 23 and 25. In particular, if the error rate FHL is the lowest error rate, then the adjustment unit 65 controls the gain control unit 66 to establish the operation mode wherein the process executed at step S51 is executed. If the error rate FML is the lowest error rate, then the adjustment unit 65 controls the gain control unit 66 to establish the operation mode wherein the process executed at step S54 is executed. If the error rate FLH is the lowest error rate, then the adjustment unit 65 controls the gain control unit 66 to establish the operation mode wherein the process executed at step S57 is executed. If the error rate NHL is the lowest error rate, then the adjustment unit 65 controls the gain control unit 66 to establish the operation mode wherein the process executed at step S60 is executed. If the error rate NML is the lowest error rate, then the adjustment unit 65 controls the gain control unit 66 to establish the operation mode wherein the process executed at step S63 is executed. If the error rate NLH is the lowest error rate, then the adjustment unit 65 controls the gain control unit 66 to establish the operation mode wherein the process executed at step S66 is executed.

Referring back to FIG. 3, after the adjustment process at step S12 ends, the power supply control section 16 stops the power supply to the high frequency processing section 11 and the demodulation section 12. Thereafter, the processing returns to step S1.

By the processes described above, error rates are determined in accordance with a combination of the operation state of the bypass switch 22 and the amplification factors of the variable amplification units 23 and 25, and the operation mode corresponding to the lowest one of the error rates is selected and used for adjustment.

For example, in such a case that the broadcasting signal being received is so high that the level is saturated as a result of amplification by the amplification unit 21 and an error occurs in the later processing, the bypass switch 22 is switched on so that the broadcasting signal can be supplied to the mathematical operation processing section 14 bypassing the amplification unit 21. Meanwhile, as regards the combination of amplification factors of the variable amplification units 23 and 25, usually the variable amplification unit 23 is set to the high amplification factor while the variable amplification unit 25 is set to the low amplification factor such that the level of the broadcasting signal to be supplied to the frequency conversion unit 24 is raised so that the frequency conversion unit 24 frequency converts a desired signal, whereafter the low amplification factor necessary for demodulation is used. However, if a jamming beam of a high level or the like is generated in a frequency band in the proximity of a desired broadcasting wave, then the radio wave which is not desired is amplified and also the undesired signal is frequency converted, and as a result, the error rate may rise. In such an instance, such a countermeasure that the amplification factor of the variable amplification unit 23 is lowered to the medium level while the amplification factor of the variable amplification unit 25 is maintained or the amplification factor of the variable amplification unit 23 is lowered to the low level while the amplification factor of the variable amplification unit 25 is raised may be taken so that only a desired signal may be supplied more effectively to the demodulation section 12 to lower the error rate.

Therefore, by changing over the combination of operations of the bypass switch 22 and the variable amplification units 23 and 25 as at steps S51, S54, S57, S60, S63 and S66 as described above and comparing the error rates in the combinations with one another to select the operations which exhibit the lowest error rate, an optimum state can be used for reception. Further, if the number of combinations of operations is increased, then more optimum conditions can be found out.

Further, since the adjustment process described above is executed at a timing at which a broadcasting signal of a selected channel is not received, the reception can be continued in an optimum state without suffering from such a situation that an image or sound being received is interrupted.

Further, since, when the adjustment process ends, a next reception timing comes and, within the time until power supply is started by the process at step S2, power supply is stopped by the process at step S13, no power consumption occurs although the period is short. Then, since a similar process is repeated and a period within which power supply stops is provided repetitively, the power consumption can be reduced.

Further, when the adjustment process ends, within the period till a next reception timing, no power consumption occurs as a result of the process at step S13, and therefore, as the time required for the adjustment process decreases, the power consumption decreases. Further, in the adjustment process, the time used for error rate calculation increases in the order of the bit error rate, block error rate and frame error rate. In other words, although the bit error rate can be determined from information of approximately several bits, the block error rate cannot be determined without information of several blocks. Further, for the determination of the frame error rate, information for several frames is required, and time is required for collection of the data. Consequently, generally long processing time is required for calculation of the error rates. However, the error rate whose calculation requires much time is also information whose accuracy is high because much data are used for the calculation. Therefore, for example, when it is desired to reduce the power consumption, the adjustment process based on the bit error for which the processing time is short may be selected, but, for example, where there is no anxiety about the power supply and reception of a high degree of accuracy is desired, the adjustment process based on the frame error rate which assures a high degree of accuracy although much processing time is required may be selected.

Further, while, in the foregoing description, the bit error rate, block error rate and frame error rate are used, some other error rate may be used instead or additionally. For example, a signal to noise ratio or a modulation error rate may be used.

As described above, according to an embodiment of the present invention, a broadcasting wave transmitted in a time-division multiplexed form can be received always in an on optimum condition.

Incidentally, while the series of processes described above can be executed by hardware, it may otherwise be executed by software. Where the series of processes is executed by software, a program which constructs the software is installed from a program recording medium into a computer incorporated in hardware for exclusive use or, for example, a personal computer for universal use which can execute various functions by installing various programs.

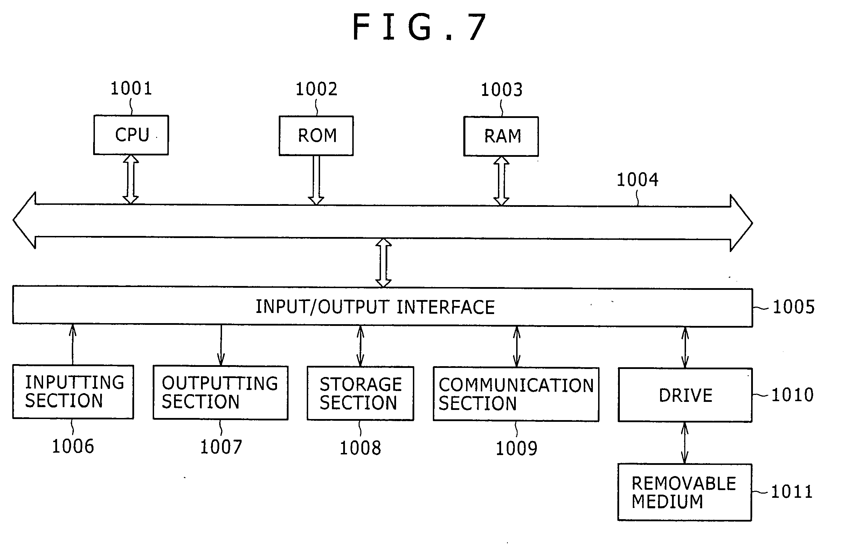

FIG. 7 shows an example of a configuration of a personal computer for universal use. Referring to FIG. 7, the personal computer shown includes a built-in central processing unit (CPU) 1001. An input/output interface 1005 is connected to the CPU 1001 through a bus 1004. A read only memory (ROM) 1002 and a random access memory (RAM) 1003 are connected to the bus 1004.

An inputting section 1006 including inputting devices such as a keyboard, a mouse and so forth for being operated by a user to input an operation command and an outputting section 1007 for outputting a processing operation screen image or an image of a result of processing. Also a storage section 1008 formed from a hard disk drive or the like for storing a program, various data and so forth and a communication section 1009 formed from a local area network (LAN) adapter or the like for executing a communication process through a network represented by the Internet are connected to the input/output interface 105. Further, a drive 1010 is connected to the input/output interface 1005. The drive 1010 reads and writes data from and on a removable medium 1011 such as a magnetic disk (including a flexible disk), an optical disk (including a CD-ROM (Compact Disk-Read Only Memory) and a DVD (Digital Versatile Disk)), a magneto-optical disk (including an MD (Mini Disc)), or a semiconductor memory.

The CPU 1001 executes various processes in accordance with a program stored in the ROM 1002 or a program read out from the removable medium 1011 such as a magnetic disk, an optical disk, a magneto-optical disk or a semiconductor memory and installed into the storage section 1008 and then loaded from the storage section 1008 into the RAM 1003. Also data and so forth necessary for the CPU 1001 to execute various processes are stored suitably into the RAM 1003.

It is to be noted that, in the present specification, the steps which are executed based on the program include not only processes which are executed in a time series in the order as described but also processes which may be but need not necessarily be processed in a time series but may be executed in parallel or individually without being processed in a time series.

While a preferred embodiment of the present invention has been described using specific terms, such description is for illustrative purpose only, and it is to be understood that changes and variations may be made without departing from the scope of the following claims.

## Claims

1. A reception device, **characterized by**:
a reception section (2) configured to receive a broadcasting wave with which multi-channel programs are transmitted time-divisionally;
an amplification unit (21, 23 or 25) configured to amplify a broadcasting signal based on the broadcasting wave received by said reception section (2);
a demodulation section (41) configured to demodulate the broadcasting signal amplified by said amplification unit (21, 23 or 25);
an error correction section (43, 46 or 49) configured to correct errors generated upon the demodulation by said demodulation section (41);
an error rate calculation section (61, 62 or 63) configured to calculate error rates of the errors corrected by said error correction section (43, 46 or 49);
an operation changeover block (65c) configured to change over operation of said amplification unit (21, 23 or 25) between or among a plurality of operation states;
a comparison section (65b) configured to compare the error rates obtained for the plurality of operation states to which the operation of said amplification unit (21, 23 or 25) is changed over by said operation changeover block (65c); and
an adjustment unit (65) configured to adjust the operation state of said amplification unit (21, 23 or 25) to that one of the operation states which exhibits the lowest error rate based on a result of the comparison by said comparison section (65b).

2. The reception device according to claim 1, **characterized in that**, at a timing at which said reception section (2) does not receive the broadcasting wave of a selected one of the multi-channel programs transmitted in a time-division multiplexed form, said operation changeover block (65c) changes over the operation state of said amplification unit (21, 23 or 25) between or among the plurality of operation states and said comparison section (65b) compares the error rates for the individual operation states between or among which the operation state of said amplification unit (21, 23 or 25) is changed over by said operation changeover block (65c) and then said adjustment unit (65) adjusts the operation state of said amplification unit (21, 23 or 25) to that one of the operation states which exhibits the lowest error rate based on a result of the comparison by said comparison section (65b).

3. The reception device according to claim 1, **characterized in that** said amplification unit (21, 23 or 25) includes:
a first amplification unit (21) having a bypass function and configured to carry out fixed amplification;
a second amplification unit (23) configured to variably amplify the signal amplified by said first amplification unit (21);
a frequency conversion unit (24) configured to frequency convert the signal amplified by said second amplification unit (23); and
a third amplification unit (25) configured to variably amplify the signal frequency converted by said frequency conversion unit (24);
said operation changeover block (65c) changing over the combination of an on/off state of said bypass function and amplification factors of said second and third amplification unit to change over the operation state of said amplification unit (21, 23 or 25);
said adjustment unit (65) changing over the combination of the on/off state of said bypass function and the amplification factors of said second and third amplification unit based on a result of the comparison by said comparison section (65b) to change over the operation state of said amplification unit (21, 23 or 25) to adjust the operation state of said amplification unit (21, 23 or 25) to that one of the operation states which exhibits the lowest error rate.

4. The reception device according to claim 1, wherein said error calculation section (61, 62 or 63) calculates one of a signal to noise ratio, a modulation error rate, a bit error rate, a block error rate and a frame error rate as the error rate of the errors to be corrected by said error correction section (43, 46 or 49).

5. A reception method, **characterized by**:
a reception step (S3) of receiving a broadcasting wave with which multi-channel programs are transmitted time-divisionally;
an amplification step (S4, S5 or S7) of amplifying a broadcasting signal based on the broadcasting wave received by the process at the reception step (S3);
a demodulation step (S21) of demodulating the broadcasting signal amplified by the process at the amplification step (S4, S5 or S);
an error correction step (S23, S29 or S36) of correcting errors generated upon the demodulation by the process at the demodulation step (S21);
an error rate calculation step (S84, S88 or S91) of calculating error rates of the errors corrected by the process at the error correction step (S23, S29 or S36);
an operation changeover step (S51, S54, S57, S60, S63 or S66) of changing over operation at the amplification step (S4, S5 or S7) between or among a plurality of operation states;
a comparison step (S69) of comparing the error rates obtained for the plurality of operation states to which the operation at the amplification step (S4, S5 or S7) is changed over by the process at the operation changeover step (S51, S54, S57, S60, S63 or S66); and
an adjustment step (S70) of adjusting the operation state at the amplification step (S4, S5 or S7) to that one of the operation states which exhibits the lowest error rate based on a result of the comparison by the process at the comparison step (S69).

6. A program, **characterized in that** said program causes a computer to execute a process which includes:
a reception step (S3) of receiving a broadcasting wave with which multi-channel programs are transmitted time-divisionally;
an amplification step (S4, S5 or S7) of amplifying a broadcasting signal based on the broadcasting wave received by the process at the reception step (S3);
a demodulation step (S21) of demodulating the broadcasting signal amplified by the process at the amplification step (S4, S5 or S7);
an error correction step (S23, S29 or S36) of correcting errors generated upon the demodulation by the process at the demodulation step (S21);
an error rate calculation step (S84, S88 or S91) of calculating error rates of the errors corrected by the process at the error correction step (S23, S29 or S36);
an operation changeover step (S51, S54, S57, S60, S63 or S66) of changing over operation at the amplification step (S4, S5 or S7) between or among a plurality of operation states;
a comparison step (S69) of comparing the error rates obtained for the plurality of operation states to which the operation at the amplification step (S4, S5 or S7) is changed over by the process at the operation changeover step (S51, S54, S57, S60, S63 or S66); and
an adjustment step (S70) of adjusting the operation state at the amplification step (S4, S5 or S7) to that one of the operation states which exhibits the lowest error rate based on a result of the comparison by the process at the comparison step (S69).

7. A program storage medium storing the program which causes a computer to execute a process **characterized by**:
a reception step (S3) of receiving a broadcasting wave with which multi-channel programs are transmitted time-divisionally;
an amplification step (S4, S5 or S7) of amplifying a broadcasting signal based on the broadcasting wave received by the process at the reception step (S3);
a demodulation step (S21) of demodulating the broadcasting signal amplified by the process at the amplification step (S4, S5 or S7);
an error correction step (S23, S29 or S36) of correcting errors generated upon the demodulation by the process at the demodulation step (S21);
an error rate calculation step (S84, S88 or S91) of calculating error rates of the errors corrected by the process at the error correction step (S23, S29 or S36);
an operation changeover step (S51, S54, S57, S60, S63 or S66) of changing over operation at the amplification step (S4, S5 or S7) between or among a plurality of operation states;
a comparison step (S69) of comparing the error rates obtained for the plurality of operation states to which the operation at the amplification step (S4, S5 or S7) is changed over by the process at the operation changeover step (S51, S54, S57, S60, S63 or S66); and
an adjustment step (S70) of adjusting the operation state at the amplification step (S4, S5 or S7) to that one of the operation states which exhibits the lowest error rate based on a result of the comparison by the process at the comparison step (S69).
